(19) Europäisches Patentamt
European Patent Office
Office européen des brevets

(11) EP 3 944 303 A1

(12) EUROPEAN PATENT APPLICATION
published in accordance with Art. 153(4) EPC

(43) Date of publication:
26.01.2022 Bulletin 2022/04

(51) International Patent Classification (IPC):
$H01L\ 23/12^{(2006.01)}$   $H01L\ 23/36^{(2006.01)}$
$H01L\ 23/373^{(2006.01)}$   $H01L\ 33/62^{(2010.01)}$
$H01L\ 21/60^{(2006.01)}$

(21) Application number: 20779040.3

(22) Date of filing: 18.03.2020

(52) Cooperative Patent Classification (CPC):
H01L 23/12; H01L 23/36; H01L 23/373;
H01L 33/62; H01L 2224/16225

(86) International application number:
PCT/JP2020/011883

(87) International publication number:
WO 2020/196132 (01.10.2020 Gazette 2020/40)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 22.03.2019 JP 2019055366

(71) Applicant: Mitsubishi Materials Corporation
Tokyo 100-8117 (JP)

(72) Inventors:
• ISHIKAWA, Fumiaki
Naka-shi, Ibaraki 311-0102 (JP)
• YAMAGUCHI, Tomohiko
Naka-shi, Ibaraki 311-0102 (JP)
• MASUYAMA, Kotaro
Naka-shi, Ibaraki 311-0102 (JP)
• IWATA, Koutarou
Naka-shi, Ibaraki 311-0102 (JP)

(74) Representative: Hoffmann Eitle
Patent- und Rechtsanwälte PartmbB
Arabellastraße 30
81925 München (DE)

(54) **JOINED STRUCTURE**

(57) The joined structure of the present invention is a joined structure in which a substrate having a circuit pattern and a member to be joined including an electrode terminal are joined together via a conductive joining material. When a contact area between the circuit pattern and the conductive joining material is defined as X, a contact area between the electrode terminal and the conductive joining material is defined as Y, and a thermal conductivity of the conductive joining material is defined as λ, the joined structure satisfies the following Formula (1), SQRT (X)/SQRT (Y) ≥ 2.9209 × $λ^{-0.141}$ (1).

FIG. 1

**Description**

TECHNICAL FIELD

The present invention relates to a joined structure.
Priority is claimed on Japanese Patent Application No. 2019-055366, filed March 22, 2019, the content of which is incorporated herein by reference.

BACKGROUND ART

Metal base substrates are known as one of substrates for mounting electronic components such as LED chips and power modules. Such metal base substrates are laminates in which a metal substrate, an insulating layer, and a circuit layer are laminated in this order. A circuit layer is molded on a predetermined circuit pattern, and an electrode terminal of an electronic component is joined onto the circuit pattern via a conductive joining material such as solder (Patent Document 1). In the metal base substrates having such a configuration, the heat generated in the electronic component is transferred to a metal substrate via the insulating layer and radiated from the metal substrate to the outside.
It is preferable that a joined structure in which a member to be joined provided with an electrode terminal such as an electronic component and a circuit pattern are joined together can efficiently release heat generated in the member to be joined to the outside, that is, has high heat dissipation performance. In order to enhance the heat dissipation performance of the joined structure, it has been studied to improve the thermal conductivity of the conductive joining material (Patent Documents 2 to 5).

Citation List

Patent Documents

Patent Document 1: Japanese Unexamined Patent Application, First Publication No. 2014-103314
Patent Document 2: Japanese Unexamined Patent Application, First Publication No. 2018-172792
Patent Document 3: Japanese Unexamined Patent Application, First Publication No. 2018-168226
Patent Document 4: Japanese Unexamined Patent Application, First Publication No. 2018-152176
Patent Document 5: Japanese Unexamined Patent Application, First Publication No. 2016-204733

SUMMARY OF INVENTION

Technical Problem

Meanwhile, the amount of heat generated in the joined structure has tended to increase with the recent increases in capacity and output of electronic devices. However, there is a limit to coping with further increases in capacity and output of the electronic devices only by improving the thermal conductivity of the joining material.
The present invention has been made in view of the aforementioned circumstances, and an object of the present invention is to provide a joined structure capable of improving the heat dissipation performance of a joined structure in which a member to be joined having an electrode terminal such as an electronic component and a circuit pattern are joined together, that is, efficiently releasing the heat generated in the member to be joined to the outside.

Solution to Problem

In order to solve the above problems, the joined structure (hereinafter, referred to as "the joined structure of the present invention") of one aspect of the present invention is a joined structure in which a substrate having a circuit pattern and a member to be joined including an electrode terminal are joined together via a conductive joining material. When a contact area between the circuit pattern and the conductive joining material is defined as X, a contact area between the electrode terminal and the conductive joining material is defined as Y, and a thermal conductivity of the conductive joining material is defined as $\lambda$, the joined structure satisfies the following Formula (1):

$$\mathrm{SQRT}\,(X)/\mathrm{SQRT}\,(Y) \geq 2.9209 \times \lambda^{-0.141}\ (1)$$

In the joined structure of the present invention, the contact area X between the circuit pattern and the conductive joining material, the contact area Y between the electrode terminal and the conductive joining material, and the thermal conductivity $\lambda$ of the conductive joining material satisfy the relationship of the above Formula (1). Thus, the thermal resistance of the joined structure is reduced. For this reason, the heat generated in the member to be joined can be efficiently released to the outside.

Here, in the joined structure of the present invention, the member to be joined may be an LED chip or a power module.

In this case, although the amount of heat generated by the LED chip and the power module has increased with the recent increase in functionality and miniaturization of electronic devices, the joined structure of the present invention has high heat dissipation performance. Therefore, even when the member to be joined is the LED chip or the power module, the member to be joined exhibits excellent heat dissipation performance, and the deterioration of the LED chips and power modules due to heat can be suppressed.

Additionally, in the joined structure of the present invention, the conductive joining material is preferably a sintered body of at least one type of metal particles selected from the group consisting of silver particles, copper particles, and copper particles coated with tin.

In this case, since the conductive joining material has high thermal conductivity, the heat generated by the member to be joined can be more reliably released to the outside efficiently. Additionally, since the sintered body of the metal particles does not melt and have fluidity even in a high-temperature state, the member to be joined can be stably fixed.

ADVANTAGEOUS EFFECTS OF INVENTION

According to the present invention, it is possible to provide a joined structure capable of efficiently releasing the heat generated in a member to be joined to the outside.

BRIEF DESCRIPTION OF DRAWINGS

Fig. 1 is a schematic cross-sectional view of a joined structure according to an embodiment of the present invention.
Fig. 2 is a cross-sectional view schematically showing a joined structure used in a simulation for verifying Formula (1).
Fig. 3 is a plan view of the joined structure shown in Fig. 2.
Fig. 4 is a graph showing a relationship between SQRT (X)/SQRT (Y) and relative thermal resistance, which was obtained by the simulation.
Fig. 5 is a graph showing a relationship between a thermal conductivity $\lambda$ of a conductive joining material and SQRT (X)/SQRT (Y) when the relative thermal resistance of the joined structure is reduced by 2%, which was obtained by the simulation.

DESCRIPTION OF EMBODIMENTS

Hereinafter, a joined structure according to an embodiment of the present invention will be described with reference to the attached drawings.

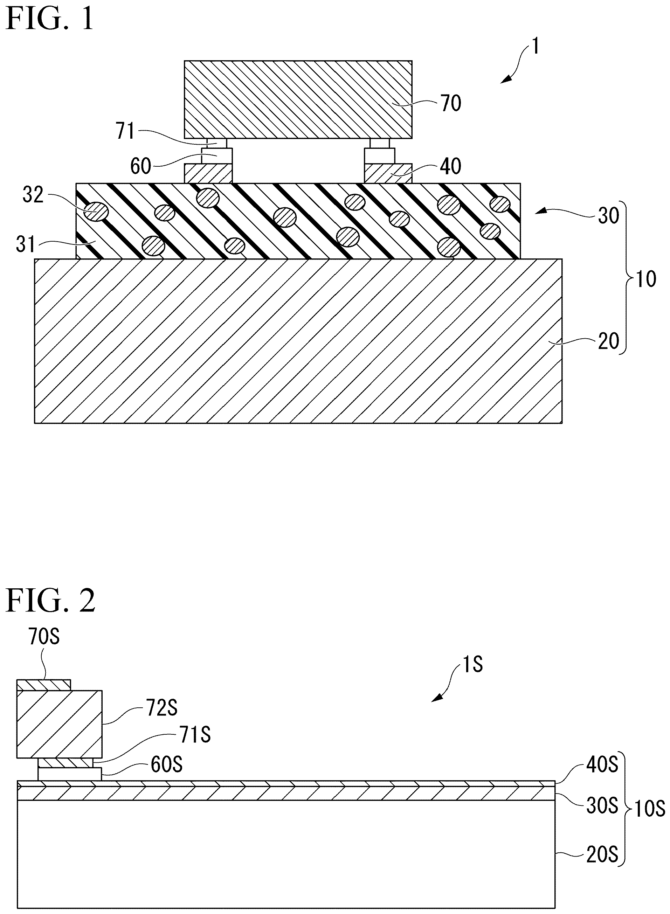

Fig. 1 is a schematic cross-sectional view of a joined structure according to the embodiment of the present invention.

In Fig. 1, a joined structure 1 is a structure in which a metal base substrate 10 and a member to be joined 70 are joined. The metal base substrate 10 is a laminate in which a metal substrate 20, an insulating layer 30, and a circuit pattern 40 are laminated in this order. The member to be joined 70 includes an electrode terminal 71. The circuit pattern 40 of the metal base substrate 10 and the electrode terminal 71 of the member to be joined 70 are joined together via a conductive joining material 60.

The joined structure 1 is adapted such that a contact area X (unit: mm$^2$) between the circuit pattern 40 and the conductive joining material 60, a contact area Y (unit: mm2) between the electrode terminal 71 and the conductive joining material 60, and a thermal conductivity $\lambda$ (unit: W/mK) of the conductive joining material 60 satisfy the following Formula (1).

$$\text{SQRT (X)/SQRT (Y)} \geq 2.9209 \times \lambda^{-0.141} \quad (1)$$

In Formula (1), SQRT represents the square root. That is, SQRT (X)/SQRT (Y) is the ratio of the square root of the contact area X between the circuit pattern 40 and the conductive joining material 60 to the square root of the contact area Y between the electrode terminal 71 and the conductive joining material 60. The SQRT (X)/SQRT (Y) is preferably 100 or less.

In the joined structure 1, by setting the contact area X and the contact area Y so as to satisfy the above Formula (1) with respect to the conductive joining material 60 having the thermal conductivity $\lambda$, the thermal resistance is reduced, the conductivity of heat from the electrode terminal 71 to the circuit pattern 40 is improved, and the heat transferred to the circuit pattern 40 is easily diffused in the metal base substrate 10.

The contact area Y between the electrode terminal 71 and the conductive joining material 60 varies depending on the power-supply voltage of the member to be joined 70 and the like but is preferably within a range of 50% or more and 90% or less of the bottom area of the member to be joined 70. When the contact area Y is within the above range, electric power can be stably supplied to the member to be joined 70, and the conductivity of the heat generated in the member to be joined 70 from the electrode terminal 71 to the circuit pattern 40 is improved.

The metal substrate 20 is a member that serves as a base for the metal base substrate 10. As the metal substrate 20, a copper plate, an aluminum plate, and a laminated plate thereof can be used.

The insulating layer 30 is a layer for insulating the metal substrate 20 and the circuit pattern 40 from each other. The insulating layer 30 is formed of an insulating resin composition containing an insulating resin 31 and ceramic particles 32 (thermally conductive filler). By forming the insulating layer 30 of the insulating resin composition containing the insulating resin 31 having a high insulating property and the ceramic particles 32 having a high thermal conductivity, the thermal resistance of the entire metal base substrate 10 from the circuit pattern 40 to the metal substrate 20 can be further reduced while maintaining the insulating property.

The insulating resin 31 is preferably a polyimide resin, a polyamide-imide resin, or a mixture thereof. Since the polyimide resin and the polyamide-imide resin have an imide bond, these resins have excellent heat resistance and mechanical characteristics.

As the ceramic particles 32, silica (silicon dioxide) particles, alumina (aluminum oxide) particles, boron nitride (BN) particles, titanium oxide particles, alumina-doped silica particles, alumina hydrate particles, aluminum nitride particles, and the like can be used. As the ceramic particles 32, one type may be used alone, or two or more types may be used in combination. Among these ceramic particles, alumina particles are preferable in that the alumina particles have a high thermal conductivity. The form of the ceramic particles 32 is not particularly limited but is preferably agglomerated particles of fine ceramic particles, or single-crystal ceramic particles.

The agglomerated particles of the fine ceramic particles may be agglomerates in which primary particles are relatively weakly linked, or may be aggregates in which the primary particles are relatively strongly linked. Additionally, the agglomerated particles may form a particle assembly in which the aggregated particles are further assembled. When the primary particles of the ceramic particles 32 form agglomerated particles and are dispersed in the insulating layer 30, a network is formed by mutual contact between the ceramic particles 32, heat is easily conducted between the primary particles of the ceramic particles 32, and the thermal conductivity of the insulating layer 30 is improved.

As commercially available products of the agglomerated particles of the fine ceramic particles, silica particles such as AE50, AE130, AE200, AE300, AE380, AE90E (all manufactured by Nippon Aerosil Co., Ltd.), T400 (manufactured by Wacker Chemie AG), and SFP-20M (manufactured by Denka Co., Ltd.), alumina particles such as Alu65 (manufactured by Nippon Aerosil Co., Ltd.) and AA-04 (manufactured by Sumitomo Chemical Co., Ltd.), boron nitride particles such as AP-170S (manufactured by Maruka Corp.), titanium oxide particles such as AEROXIDE (R) TiO2 P90 (manufactured by Nippon Aerosil Co., Ltd.), alumina-doped silica particles such as MOX170 (manufactured by Nippon Aerosil Co., Ltd.), alumina hydrate particles manufactured by Sasol Ltd., and the like can be used.

The single-crystal ceramic particles are preferably $\alpha$-alumina single crystal particles having a crystal structure of $\alpha$-alumina ($\alpha Al_2O_3$). As commercially available products of the $\alpha$-alumina single crystal particles, AA-03, AA-04, AA-05, AA-07, AA-1.5, and the like of the Advanced Alumina (AA) series sold by Sumitomo Chemical Co., Ltd. can be used.

The content of the ceramic particles 32 in the insulating layer 30 is preferably in a range of 5% by volume or more and 60% by volume or less. When the content of the ceramic particles 32 is too small, there is a concern that the thermal conductivity of the insulating layer 30 is not sufficiently improved. On the other hand, when the content of the ceramic particles 32 too large, there is a concern that the content of the insulating resin 31 is relatively reduced and the shape of the insulating layer 30 is not stably maintained. Additionally, there is a concern that the ceramic particles 32 tend to form excessively large agglomerated particles and a surface roughness Ra of the insulating layer 30 is increased. In order to reliably improve the thermal conductivity of the insulating layer 30, the content of the ceramic particles 32 is preferably 10% by volume or more. Additionally, in order to reliably improve the shape stability of the insulating layer 30 and reduce the surface roughness Ra, the content of the ceramic particles 32 is particularly preferably 50% by volume or less.

The film thickness of the insulating layer 30 is not particularly limited, but is preferably in a range of 1 $\mu$m or more and 200 $\mu$m or less, and particularly preferably in a range of 3 $\mu$m or more and 100 $\mu$m or less.

As the material of the circuit pattern 40, aluminum, copper, silver, gold, tin, iron, nickel, chromium, molybdenum, tungsten, palladium, titanium, zinc, and alloys of these metals can be used. Among these metals, aluminum and copper are preferable, and aluminum is particularly preferable. The method of molding the circuit pattern 40 is not particularly limited, and for example, an etching method can be used.

The film thickness of the circuit pattern 40 is preferably in a range of 10 μm or more and 1000 μm or less, and particularly preferably in a range of 20 μm or more and 100 μm or less. When the film thickness of the circuit pattern 40 is too small, there is a concern that the thermal resistance increases. On the other hand, when the film thickness of the circuit pattern 40 is too large, there is a concern that it is difficult to form the circuit pattern by the etching method. Additionally, when the film thickness of the circuit pattern 40 is too large, there is a concern that the thermal stress applied to the circuit pattern 40 increases due to a difference between the coefficients of thermal expansion of respective materials constituting the joined structure 1, and the insulating layer 30 and the circuit pattern 40 are easily separated from each other during a cold-hot cycle.

Examples of the member to be joined 70 are not particularly limited, and semiconductor elements, resistors, capacitors, crystal oscillators, and the like are exemplary examples. As examples of the semiconductor elements, metal-oxide-semiconductor field-effect transistors (MOSFETs), insulated gate bipolar transistors (IGBTs), large-scale integrations (LSIs), light-emitting diodes (LEDs), LED chips, and LED-chip size packages (LED-CSPs) are exemplary examples.

As the materials of the conductive joining material 60, metals or alloys can be used. The conductive joining material 60 is preferably a sintered body of metal particles. As the metal particles, silver particles, copper particles, and copper particles (tin-coated copper particles) coated with tin can be used. One type of these metal particles may be used alone, or two or more types of these metal particles may be used in combination. The thickness of the conductive joining material 60 is preferably in a range of 1 μm or more and 100 μm or less.

The sintered body of the metal particles can be formed by heating a paste containing the metal particles in a state in which the paste is interposed between the circuit pattern 40 of the metal base substrate 10 and the electrode terminal 71 of the member to be joined 70 to sinter the metal particles.

Next, a method of manufacturing the joined structure of the present embodiment will be described.

The joined structure can be manufactured by, for example, a method including an application step of applying a metal particle paste to a circuit pattern of a metal base substrate to form a metal particle paste layer, a loading step of loading a member to be joined on the metal particle paste layer, and a joining step of heating the metal base substrate on which the member to be joined is loaded to produce a metal particle sintered body.

In the application step, the application amount of the metal particle paste is set such that a thermal conductivity λ of the metal particle sintered body produced by heating the metal particle paste is obtained in advance and a contact area X between the metal particle sintered body produced by heating the metal particle paste and the circuit pattern and a contact area Y between the metal particle sintered body and an electrode terminal satisfy the above Formula (1). As a method of applying the metal particle paste to the circuit pattern of the metal base substrate, a method such as a screen printing method can be used.

In the loading step, the member to be joined is loaded such that the electrode terminals of the members to be joined are in contact with the metal particle paste layer.

In the joining step, it is preferable to heat the metal base substrate while pressurizing the member to be joined. The heating temperature of the metal base substrate is a temperature at which the metal particles of the metal particle paste are sintered and is preferably in a range of 200°C or higher and 350°C or lower. The heating atmosphere is preferably a non-oxidizing atmosphere.

According to the joined structure 1 of the present embodiment having the configuration as described above, the contact area X between the circuit pattern 40 and the conductive joining material 60, the contact area Y between the electrode terminal 71 of the member to be joined 70 and the conductive joining material 60, and the thermal conductivity λ of the conductive joining material 60 satisfy the relationship of the above Formula (1). Thus, the thermal resistance of the joined structure 1 is reduced. For this reason, the heat generated in the member to be joined can be efficiently released to the outside.

Additionally, in the joined structure 1 of the present embodiment, the member to be joined 70 exhibits excellent heat dissipation performance even in an LED chip or a power module, and deterioration of the LED chip and the power module due to heat can be suppressed.

Additionally, in the joined structure 1 of the present embodiment, in a case where the conductive joining material 60 is a sintered body of at least one type of metal particles selected from the group consisting of silver particles, copper particles, and copper particles coated with tin, the conductive joining material 60 has high thermal conductivity. Thus, the heat generated by the member to be joined 70 can be more reliably released to the outside efficiently.

The embodiment of the present invention has been described above, but the present invention is not limited thereto and can be appropriately changed without departing from the technical ideas of the present invention.

For example, in the joined structure 1 of the present embodiment, as the conductive joining material 60, sintered bodies of metal particles such as silver particles, copper particles, and copper particles coated with tin have been exemplified. However, the conductive joining material 60 is not limited to these. For example, solder may be used as the conductive joining material 60.

EXAMPLES

Hereinafter, the action and effects of the present invention will be described by way of Examples.

[Example 1 of present invention: simulation]

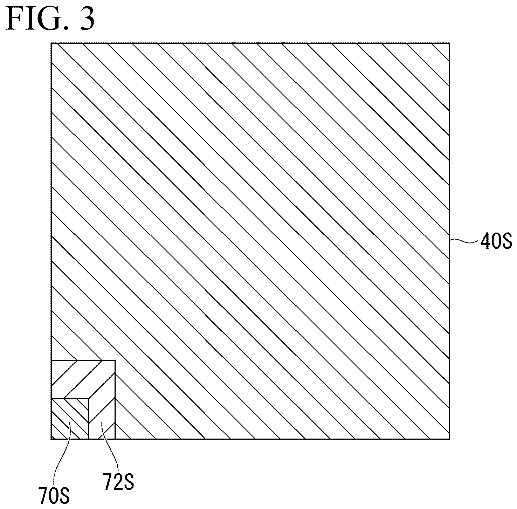

Fig. 2 is a cross-sectional view schematically showing a joined structure used in the simulation for verifying Formula (1). Fig. 3 is a plan view of the joined structure of Fig. 2. The simulation was performed using a LISA finite element analysis system (manufactured by Sonnenhof Holdings).

In a joined structure 1S shown in FIGS. 2 and 3, a metal base substrate 10S is a laminate in which a metal substrate 20S, an insulating layer 30S, and a copper foil 40S are laminated in this order. The copper foil 40S is entirely formed on the insulating layer 30S. A member to be joined 70S is connected to an electrode terminal 71S via an aluminum nitride (A1N) member 72S. The member to be joined 70S is an LED chip, and the electrode terminal 71S is a copper terminal. The characteristics of each member of the joined structure 1S are as follows.

Metal substrate 20S: Plane size: 5 mm $\times$ 5 mm, Heat transfer coefficient: 300 W/m$^2$K
Insulating layer 30S: Thickness: 100 $\mu$m, Thermal conductivity: 10 W/mK
Copper foil 40S: Thickness: 35 $\mu$m, Thermal conductivity: 400 W/mK
Conductive joining material 60S: Thickness and thermal conductivity are described in Table 1 below.
Electrode terminal 71S: Thickness: 35 $\mu$m, Thermal conductivity: 400 W/mK
A1N member 72S: Thickness: 635 $\mu$m, Thermal conductivity: 170 W/mK
Member to be joined 70S: Thickness: 100 $\mu$m, Thermal conductivity: 1,000,000,000 W/mK, Heat generation density: 20 W/m$^3$

A contact area X (mm$^2$) between the copper foil 40S and the conductive joining material 60S, a contact area Y (mm$^2$) between the electrode terminal 71S and the conductive joining material 60S, and SQRT (X)/SQRT (Y) are described in Table 1 below.

The heat distribution of the joined structure 1S when the member to be joined 70S generates heat was obtained by simulation. Then, a maximum temperature (°C), a minimum temperature (°C), and a temperature difference between the maximum temperature and the minimum temperature (Maximum temperature - Minimum temperature) in each member of the joined structure 1S were obtained. The results are shown in Table 1.

Additionally, the thermal resistance in the joined structure 1S was calculated from the temperature difference between the maximum temperature and the minimum temperature of the joined structure 1S and the amount of heat generated (W) of the member to be joined 70S from the following formula. Then, the relative value of the thermal resistance in a case where the thermal resistance of SQRT (X)/SQRT (Y) = 1.2 is 100 for the joined structure 1S having the same thermal conductivity $\lambda$ as the conductive joining material 60S but different SQRT (X)/SQRT (Y) was obtained. This result is shown in Table 1 as the relative thermal resistance (%).

$$\text{Thermal resistance (K/W)} = \text{(Maximum temperature - Minimum temperature)/Amount of heat generated}$$

Table 1

| No. | Conductive Joining Member | | Contact Area X between Copper Foil and Conductive Joining Member (mm$^2$) | Contact Area Y between Copper Terminal and Conductive Joining Member (mm$^2$) | SQRT (X) / SQRT (Y) | Simulation Result | | | |
|---|---|---|---|---|---|---|---|---|---|
| | Thickness (μm) | Thermal Conductivity λ (W/mK) | | | | Maximum Temperature (°C) | Minimum Temperature (°C) | Maximum Temperature - Minimum Temperature (°C) | Relative Thermal Resistance (%) |
| 1 | 100 | 200 | 2.45 | 1.7 | 1.2 | 100.70 | 91.43 | 9.27 | 100 |
| 2 | 100 | 200 | 4.35 | 1.7 | 1.6 | 100.30 | 91.43 | 8.87 | 95.7 |
| 3 | 100 | 200 | 6.80 | 1.7 | 2.0 | 100.10 | 91.43 | 8.67 | 93.5 |
| 4 | 100 | 200 | 27.20 | 1.7 | 4.0 | 99.89 | 91.44 | 8.45 | 91.2 |
| 5 | 100 | 200 | 90.59 | 1.7 | 7.3 | 99.87 | 91.44 | 8.43 | 90.9 |
| 6 | 100 | 30 | 2.45 | 1.7 | 1.2 | 103.70 | 91.42 | 12.28 | 100 |
| 7 | 100 | 30 | 4.35 | 1.7 | 1.6 | 103.50 | 91.43 | 12.07 | 98.3 |
| 8 | 100 | 30 | 6.80 | 1.7 | 2.0 | 103.50 | 91.43 | 12.07 | 98.3 |
| 9 | 100 | 30 | 27.20 | 1.7 | 4.0 | 103.40 | 91.43 | 11.97 | 97.5 |
| 10 | 100 | 30 | 90.59 | 1.7 | 7.3 | 103.40 | 91.43 | 11.97 | 97.5 |
| 11 | 100 | 300 | 2.45 | 1.7 | 1.2 | 100.50 | 91.43 | 9.07 | 100 |
| 12 | 100 | 300 | 4.35 | 1.7 | 1.6 | 99.93 | 91.43 | 8.50 | 93.7 |
| 13 | 100 | 300 | 6.80 | 1.7 | 2.0 | 99.68 | 91.43 | 8.25 | 91.0 |
| 14 | 100 | 300 | 27.20 | 1.7 | 4.0 | 99.41 | 91.44 | 7.97 | 87.9 |
| 15 | 100 | 300 | 90.59 | 1.7 | 7.3 | 99.38 | 91.45 | 7.93 | 87.4 |
| 16 | 100 | 60 | 2.45 | 1.7 | 1.2 | 102.00 | 91.42 | 10.58 | 100 |
| 17 | 100 | 60 | 4.35 | 1.7 | 1.6 | 101.80 | 91.43 | 10.37 | 98.0 |
| 18 | 100 | 60 | 6.80 | 1.7 | 2.0 | 101.70 | 91.43 | 10.27 | 97.1 |
| 19 | 100 | 60 | 27.20 | 1.7 | 4.0 | 101.70 | 91.43 | 10.27 | 97.1 |
| 20 | 100 | 60 | 90.59 | 1.7 | 7.3 | 101.70 | 91.43 | 10.27 | 97.1 |
| 21 | 100 | 10 | 2.45 | 1.7 | 1.2 | 110.00 | 91.42 | 18.58 | 100 |

(continued)

| No. | Conductive Joining Member Thickness (μm) | Conductive Joining Member Thermal Conductivity λ (W/mK) | Contact Area X between Copper Foil and Conductive Joining Member (mm²) | Contact Area Y between Copper Terminal and Conductive Joining Member (mm²) | SQRT(X) / SQRT(Y) | Simulation Result Maximum Temperature (°C) | Simulation Result Minimum Temperature (°C) | Simulation Result Maximum Temperature - Minimum Temperature (°C) | Relative Thermal Resistance (%) |
|---|---|---|---|---|---|---|---|---|---|
| 22 | 100 | 10 | 4.35 | 1.7 | 1.6 | 109.80 | 91.42 | 18.38 | 98.9 |
| 23 | 100 | 10 | 6.80 | 1.7 | 2.0 | 109.80 | 91.42 | 18.38 | 98.9 |
| 24 | 100 | 10 | 27.20 | 1.7 | 4.0 | 109.80 | 91.42 | 18.38 | 98.9 |
| 25 | 100 | 10 | 90.59 | 1.7 | 7.3 | 109.80 | 91.43 | 18.37 | 98.9 |
| 26 | 100 | 20 | 2.45 | 1.7 | 1.2 | 105.30 | 91.42 | 13.88 | 100 |
| 27 | 100 | 20 | 4.35 | 1.7 | 1.6 | 105.10 | 91.42 | 13.68 | 98.6 |
| 28 | 100 | 20 | 6.80 | 1.7 | 2.0 | 105.10 | 91.42 | 13.68 | 98.6 |
| 29 | 100 | 20 | 27.20 | 1.7 | 4.0 | 105.10 | 91.43 | 13.67 | 98.5 |
| 30 | 100 | 20 | 90.59 | 1.7 | 7.3 | 105.10 | 91.43 | 13.67 | 98.5 |
| 31 | 100 | 100 | 2.45 | 1.7 | 1.2 | 101.30 | 91.42 | 9.88 | 100 |
| 32 | 100 | 100 | 4.35 | 1.7 | 1.6 | 101.00 | 91.43 | 9.57 | 96.9 |
| 33 | 100 | 100 | 6.80 | 1.7 | 2.0 | 100.90 | 91.43 | 9.47 | 95.9 |
| 34 | 100 | 100 | 27.20 | 1.7 | 4.0 | 100.80 | 91.43 | 9.37 | 94.8 |
| 35 | 100 | 100 | 90.59 | 1.7 | 7.3 | 100.80 | 91.43 | 9.37 | 94.8 |
| 36 | 100 | 400 | 2.45 | 1.7 | 1.2 | 100.40 | 91.43 | 8.97 | 100 |
| 37 | 100 | 400 | 4.35 | 1.7 | 1.6 | 99.72 | 91.43 | 8.29 | 92.4 |
| 38 | 100 | 400 | 6.80 | 1.7 | 2.0 | 99.42 | 91.43 | 7.99 | 89.1 |
| 39 | 100 | 400 | 27.20 | 1.7 | 4.0 | 99.07 | 91.44 | 7.63 | 85.1 |
| 40 | 100 | 400 | 90.59 | 1.7 | 7.3 | 99.03 | 91.46 | 7.57 | 84.4 |

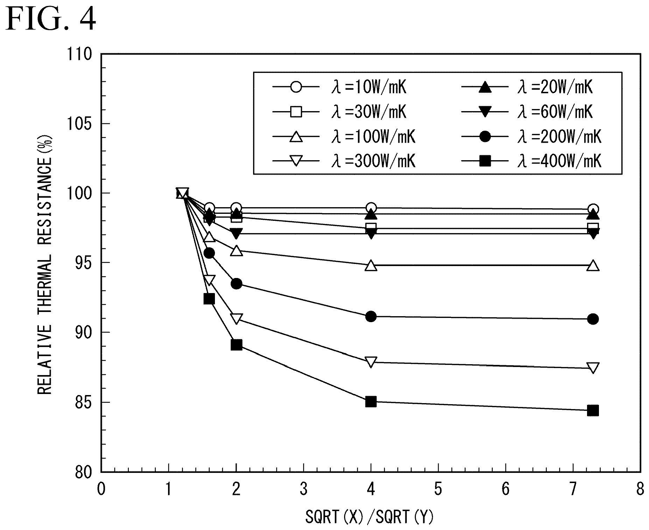

Fig. 4 is a graph showing the relationship between the SQRT (X)/SQRT (Y) and the relative thermal resistance, which was obtained in the simulation. In Fig. 4, the simulation results obtained in the joined structure 1S having the same thermal conductivity λ as the conductive joining material 60S are connected together by a line. It can be seen from the results of Fig. 4 that, in a case where the thermal conductivity λ of the conductive joining material 60S is the same, the relative thermal resistance decreases as the SQRT (X)/SQRT (Y) increases. Additionally, it can be seen that, as the thermal conductivity λ of the conductive joining material 60S increases, the amount of decrease in the relative thermal resistance that accompanies the increase in SQRT (X)/SQRT (Y) increases.

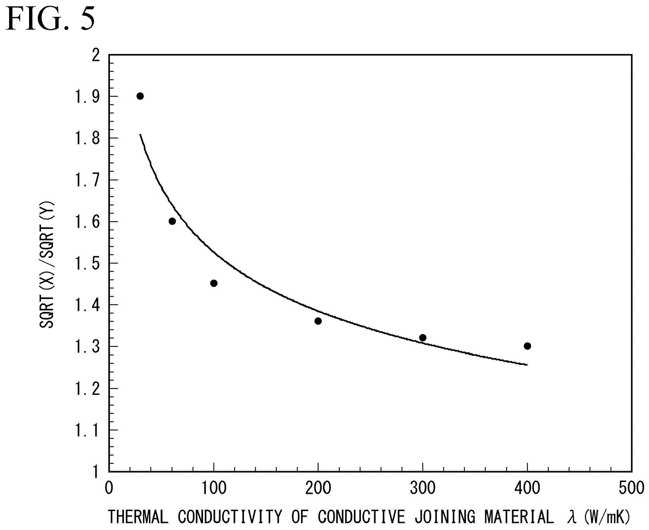

Fig. 5 is a graph showing a relationship between the thermal conductivity λ of the conductive joining material and SQRT (X)/SQRT (Y) when the relative thermal resistance of the joined structure is reduced by 2%, which was obtained by the simulation. Black circle dots in the graph shown in Fig. 5 are dots by plotting the relationship between the thermal conductivity λ of the conductive joining material 60S and SQRT (X)/SQRT (Y) when the relative thermal resistance of the joined structure 1S is reduced by 2% (when the relative thermal resistance is 98% in the graph shown in Fig. 4). Additionally, a curve in the graph is a power approximation curve obtained by data-fitting the plotted black circle dots. This power approximation curve is shown by SQRT (X)/SQRT (Y) = $2.9209 \times \lambda^{-0.141}$. In the graph shown in Fig. 5, a region above the power approximation curve is a region in which the relative thermal resistance of the joined structure 1S is reduced by 2% or more. Therefore, it can be seen from the results of Fig. 5 that, in a case where the contact area (X) between the copper foil 40S (circuit pattern) and the conductive joining material 60S of the joined structure 1S, the contact area (Y) between the electrode terminal 71S and the conductive joining material 60S (Y), and the thermal conductivity λ of the conductive joining material 60S satisfy the relationship of SQRT (X)/SQRT (Y) $\geq 2.9209 \times \lambda^{-0.141}$, the relative thermal resistance can be reduced by 2% or more.

[Example 2 of present invention: joined structure using silver particle sintered body for conductive joining material]

An insulating layer (thickness: 30 μm, alumina particle content: 60% by volume) containing an alumina particle-containing polyimide resin and a copper layer (thickness: 35 μm)) are formed on a copper substrate (30 mm × 20 mm × 0.3 mmt) were laminated in this order to produce a copper base substrate. The copper layer of this copper base substrate was etched by an etching method to form a circuit pattern.

A silver particle paste (average particle size of silver particles: 150 nm) was applied to a circuit pattern of the copper base substrate to form a silver particle paste application layer (width: 10 mm, thickness: 50 μm). Next, an electrode terminal of an LED chip (terminal size: 1.65 mm × 0.45 mm) was loaded on the silver particle paste. Then, while pressurizing (10 Pa) the loaded LED chip, heating was performed at 300°C in a nitrogen atmosphere to sinter the silver particles of the silver particle paste to produce a joined structure in which the copper base substrate and the LED chip are joined together via the silver particle sintered body.

A contact area (X) between the circuit pattern and the silver particle sintered body of the obtained joined structure, a contact area (Y) between the electrode terminal of the LED chip and the silver particle sintered body, and a thermal conductivity λ of the silver particle sintered body were each measured. Then, as a result of calculating SQRT (X)/SQRT (Y) and $2.9209 \times \lambda^{-0.141}$, SQRT (X)/SQRT (Y) was 23.2, and $2.9209 \times \lambda^{-0.141}$ was 1.3. Additionally, as a result of visually observing the obtained joined structure, no positional deviation or floating of the LED chip was confirmed.

[Example 3 of present invention: joined structure using copper particle sintered body for conductive joining material]

A joined structure in which a copper base substrate and an LED chip were joined together via a copper particle sintered body was produced similar to Example 2 of the present invention except that copper particle paste (average particle size of copper particles: 150 nm) was used instead of the silver particle paste.

A contact area (X) between the circuit pattern and the silver particle sintered body of the obtained joined structure, a contact area (Y) between the electrode terminal of the LED chip and the silver particle sintered body, and a thermal conductivity λ of the copper particle sintered body were each measured. Then, as a result of calculating SQRT (X)/SQRT (Y) and $2.9209 \times \lambda^{-0.141}$, SQRT (X)/SQRT (Y) was 23.2, and $2.9209 \times \lambda^{-0.141}$ was 1.3. Additionally, as a result of visually observing the obtained joined structure, no positional deviation or floating of the LED chip was confirmed.

[Example 4 of present invention: joined structure using tin-coated copper particle sintered body for conductive joining material]

A joined structure in which a copper base substrate and an LED chip were joined together via a tin-coated copper particle sintered body was produced similar to Example 2 of the present invention except that tin-coated copper particle paste (average particle size of tin-coated copper particles: 9 μm) was used instead of the silver particle paste.

A contact area (X) between the circuit pattern and the silver particle sintered body of the obtained joined structure, a contact area (Y) between the electrode terminal of the LED chip and the silver particle sintered body, and a thermal conductivity λ of the tin-coated copper particle sintered body were each measured. Then, as a result of calculating SQRT (X)/SQRT (Y) and $2.9209 \times \lambda^{-0.141}$, SQRT (X)/SQRT (Y) was 23.2, and $2.9209 \times \lambda^{-0.141}$ was 1.8. Additionally, as a result of visually observing the obtained joined structure, no positional deviation or floating of the LED chip was confirmed.

INDUSTRIAL APPLICABILITY

The joined structure of the present invention can efficiently release the heat generated in a member to be joined to the outside. For this reason, even when the member to be joined is an electronic component such as an LED chip or a power module that generates a large amount of heat, deterioration due to heat can be suppressed.

REFERENCE SIGNS LIST

| | |
|---|---|
| 1, 1S: | Joined structure |
| 10, 10S: | Metal base substrate |
| 20, 20S: | Metal substrate |
| 30, 30S: | Insulating layer |
| 31: | Insulating resin |
| 32: | Ceramic particle |
| 40: | Circuit pattern |
| 40S: | Copper foil |
| 60, 60S: | Conductive joining material |
| 70, 70S: | Member to be joined |
| 71, 71S: | Electrode terminal |
| 72S: | Aluminum nitride (A1N) member |

## Claims

1. A joined structure in which a substrate having a circuit pattern and a member to be joined including an electrode terminal are joined together via a conductive joining material, wherein when a contact area between the circuit pattern and the conductive joining material is defined as X, a contact area between the electrode terminal and the conductive joining material is defined as Y, and a thermal conductivity of the conductive joining material is defined as λ, the joined structure satisfies the following Formula (1),

$$\text{SQRT (X)/SQRT (Y)} \geq 2.9209 \times \lambda^{-0.141} \ (1).$$

2. The joined structure according to Claim 1,
   wherein the member to be joined is an LED chip or a power module.

3. The joined structure according to Claim 1 or 2,
   wherein the conductive joining material is a sintered body of at least one type of metal particles selected from the group consisting of silver particles, copper particles, and copper particles coated with tin.

FIG. 1

FIG. 2

## FIG. 3

FIG. 4

FIG. 5

*(Graph: Y-axis "SQRT (X) / SQRT (Y)" from 1 to 2; X-axis "THERMAL CONDUCTIVITY OF CONDUCTIVE JOINING MATERIAL $\lambda$ (W/mK)" from 0 to 500)*

## INTERNATIONAL SEARCH REPORT

| International application No. |
| --- |
| PCT/JP2020/011883 |

A. CLASSIFICATION OF SUBJECT MATTER
H01L 23/12(2006.01)i; H01L 23/36(2006.01)i; H01L 23/373(2006.01)i; H01L 33/62(2010.01)i; H01L 21/60(2006.01)i
FI: H01L23/36 D; H01L23/36 M; H01L21/60 311S; H01L23/12 J; H01L33/62
According to International Patent Classification (IPC) or to both national classification and IPC

B. FIELDS SEARCHED

Minimum documentation searched (classification system followed by classification symbols)
H01L23/12; H01L23/36; H01L23/373; H01L33/62; H01L21/60

Documentation searched other than minimum documentation to the extent that such documents are included in the fields searched
Published examined utility model applications of Japan    1922-1996
Published unexamined utility model applications of Japan    1971-2020
Registered utility model specifications of Japan    1996-2020
Published registered utility model applications of Japan    1994-2020

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| Y | JP 2014-7366 A (TOYOTA INDUSTRIES CORPORATION) 16.01.2014 (2014-01-16) paragraphs [0026]-[0097], fig. 1, 2, 4-10 | 1-3 |
| Y | JP 2018-32608 A (PANASONIC IP MANAGEMENT CO., LTD.) 01.03.2018 (2018-03-01) paragraphs [0014]-[0050], fig. 1-5 | 1-3 |
| A | JP 2013-51389 A (NGK SPARK PLUG CO., LTD.) 14.03.2013 (2013-03-14) entire text, all drawings | 1-3 |
| A | JP 2005-129874 A (SEIKO EPSON CORP.) 19.05.2005 (2005-05-19) entire text, all drawings | 1-3 |

☐ Further documents are listed in the continuation of Box C.    ☒ See patent family annex.

| | |
| --- | --- |
| *   Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
| --- | --- |
| 03 June 2020 (03.06.2020) | 16 June 2020 (16.06.2020) |

| Name and mailing address of the ISA/<br>Japan Patent Office<br>3-4-3, Kasumigaseki, Chiyoda-ku,<br>Tokyo 100-8915, Japan | Authorized officer<br><br><br>Telephone No. |
| --- | --- |

Form PCT/ISA/210 (second sheet) (January 2015)

**INTERNATIONAL SEARCH REPORT**
Information on patent family members

| International application No. |
| --- |
| PCT/JP2020/011883 |

| Patent Documents referred in the Report | Publication Date | Patent Family | Publication Date |
| --- | --- | --- | --- |
| JP 2014-7366 A | 16 Jan. 2014 | (Family: none) | |
| JP 2018-32608 A | 01 Mar. 2018 | US 2018/0062059 A1 paragraphs [0037]-[0075], fig. 1-5 DE 102017119120 A1 CN 108305934 A | |
| JP 2013-51389 A | 14 Mar. 2013 | US 2014/0138850 A1 entire text, all drawings WO 2013/018357 A1 CN 103733330 A KR 10-2014-0047097 A | |
| JP 2005-129874 A | 19 May 2005 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019055366 A
- JP 2014103314 A
- JP 2018172792 A
- JP 2018168226 A
- JP 2018152176 A
- JP 2016204733 A